## Europäisches Patentamt

## European Patent Office

## Office européen des brevets

(19)

(11) Veröffentlichungsnummer: **0 146 195**
A2

(12) **EUROPÄISCHE PATENTANMELDUNG**

(21) Anmeldenummer: 84201867.3

(22) Anmeldetag: 14.12.84

(51) Int. Cl.⁴: **H 04 B 1/16, H 03 D 1/22**

(30) Priorität: 21.12.83 DE 3346059

(43) Veröffentlichungstag der Anmeldung: 26.06.85
Patentblatt 85/26

(84) Benannte Vertragsstaaten: **DE FR GB IT**

(71) Anmelder: **Philips Patentverwaltung GmbH,
Billstrasse 80, D-2000 Hamburg 28 (DE)**
(84) Benannte Vertragsstaaten: **DE**

(71) Anmelder: **N.V. Philips' Gloeilampenfabrieken,
Groenewoudseweg 1, NL-5621 BA Eindhoven (NL)**
(84) Benannte Vertragsstaaten: **FR GB IT**

(72) Erfinder: **Nolde, Wolfgang, Im Ginsterbusch 5,
D-2000 Hamburg 61 (DE)**

(74) Vertreter: **Hartmann, Heinrich, Dipl.-Ing. et al, Philips
Patentverwaltung GmbH
Billstrasse 80 Postfach 10 51 49,
D-2000 Hamburg 28 (DE)**

(54) FM-Stereoempfänger.

(57) Bei einem FM-Stereoempfänger mit einem Stereodecoder wird das Ausgangssignal des Stereodecoders mit einem nicht sinusförmigen Signal mit Hilfsträgerfrequenz gemischt und das Mischprodukt wird zur Modulation der Frequenz eines Oszillators benutzt mit Hilfe dessen das Antennensignal in den Zwischenfrequenzbereich umgesetzt wird. Dadurch, dass das zur Modulation des Oszillators benutzte Signal frei von dritten und fünften Harmonischen der Hilfsträgerfrequenz ist, werden Empfangsstörungen vermieden.

"FM-Stereoempfänger"

Die Erfindung bezieht sich auf einen FM-Stereoempfänger mit einem Oszillator, dessen Frequenz in Abhängigkeit von einem Signal an seinem Steuereingang steuerbar ist, einer Mischstufe, die das Oszillatorsignal mit einem hochfrequenten Eingangssignal mischt und ein ZF-Signal bildet, einem FM-Demodulator, dem das ZF-Signal zugeführt und dessen Ausgangssignal dem Steuereingang des Oszillators über einen ersten Tiefpaß sowie über einen in einem Parallelzweig befindlichen Bandpaß zugeführt wird, der einen Demodulator zum Erzeugen eines Stereo-Differenzsignals beim Empfang einer Stereosendung enthält, dem ein zweiter Tiefpaß nachgeschaltet ist, dessen Ausgangssignal in einer ersten Mischeranordnung mit einem nicht sinusförmigen Signal mit Hilfsträgerfrequenz gemischt wird.

Ein solcher Stereoempfänger ist aus der europäischen Patentanmeldung 0088 467 bekannt. Der darin enthaltene Bandpaß bildet eine Voraussetzung für den Stereoempfang. Die in diesem Bandpaß enthaltene Mischeranordnung besteht aus einer einzelnen Mischstufe, der das Ausgangssignal des zweiten Tiefpasses zugeführt wird, der seinerseits das Ausgangssignal einer weiteren Mischstufe verarbeitet, in der das Ausgangssignal des FM-Demodulators mit einem Rechtecksignal mit Hilfsträgerfrequenz gemischt wird. Durch diese Mischung werden die bei einer Stereosendung am Ausgang des FM-Demodulators erscheinenden beiderseits des (unterdrückten) Hilfsträgers befindlichen Seitenbänder in die Niederfrequenzlage umgesetzt, so daß das entstehende Stereo-Differenzsignal in einer Matrixschaltung mit dem Stereo-Summensignal zwecks Erzeugung von Signalen für den linken und den rechten Kanal kombiniert werden kann.
Dieses Stereo-Differenzsignal wird über den zweiten Tiefpaß der in der ersten Mischeranordnung enthaltenen Mischstufe zugeführt und darin erneut mit einem Rechtecksignal
mit Hilfsträgerfrequenz gemischt. Zwischen diesem Rechtecksignal und dem Rechtecksignal, mit dem in der vorangehenden Mischstufe die Seitenbänder in die Niederfrequenzlage umgesetzt werden, besteht jedoch eine Phasenverschiebung. Diese Phasenverschiebung ist erforderlich, damit die aus dem Oszillator der Mischstufe dem FM-Demodulator und dem ersten Tiefpaß bzw. dem Bandpaß bestehende
Regelschleife stabil bleibt. Außerdem wird durch den Tiefpaß die Bandbreite der Seitenbänder verringert.

Ein Nachteil des bekannten Stereoempfängers besteht jedoch
darin, daß beim Empfang von Stereosignalen Störungen hörbar werden. Aufgabe der vorliegenden Erfindung ist es,
diese Störungen zu beseitigen.

Eine erste Lösung dieser Aufgabe besteht darin, daß das
der ersten Mischeranordnung zugeführte nicht sinusförmige
Signal frei von dritten und fünften Harmonischen der
Hilfsträgerfrequenz ist. Eine andere Lösung besteht darin,
daß die erste Mischeranordnung eine erste Mischstufe umfaßt, in der das Ausgangssignal des Tiefpasses mit einem
Rechtecksignal mit der Hilfsträgerfrequenz gemischt wird,
und wenigstens noch zwei weitere Mischstufen, in denen das
Ausgangssignal des Tiefpasses mit Rechtecksignalen mit der
dreifachen, der fünffachen und gegebenenfalls weiteren ungeradzahligen Vielfachen der Hilfsträgerfrequenz gemischt
wird, daß die Ausgangssignale der weiteren Mischstufen dem
Ausgangssignal der ersten Mischstufe mit solcher Amplitude
und Phasenlage überlagert werden, daß die im Ausgangssignal der ersten Mischstufe enthaltenen Mischprodukte zumindest mit der dreifachen und der fünffachen Frequenz des

0146195

Hilfsträgers wenigstens teilweise kompensiert werden.

Beide Lösungen basieren auf der Erkenntnis, daß die erwähnten Störungen dadurch verursacht werden, daß der
Oszillator außer mit den erwünschten Seitenbändern beiderseits der Hilfsträgerfrequenz noch mit weiteren Seitenbändern beiderseits der dritten und fünften und gegebenenfalls weiterer ungeradzahligen Harmonischen der Hilfsträgerfrequenz moduliert wird. Die letztgenannten Seitenbänder entstehen dadurch, daß das Ausgangssignal des
zweiten Tiefpasses in der ersten Mischeranordnung mit
einem Rechtecksignal mit Hilfsträgerfrequenz gemischt
wird. Dieses Rechtecksignal enthält außer der ersten Harmonischen noch weitere ungeradzahlige Harmonische, und die
deshalb am Ausgang der ersten Mischeranordnung erscheinenden Mischprodukte mit diesen höheren Harmonischen, insbesondere mit der dritten und der fünften Harmonischen,
können Störungen hervorrufen, die in den Nutzsignalbereich
fallen. Nach der ersten Lösung werden diese Mischprodukte
- und damit auch die in den Nutzsignalbereich fallenden
Störungen - dadurch vermieden, daß der ersten Mischeranordnung ein zumindest von dritten und fünften Harmonischen
der Hilfsträgerfrequenz freies Signal zugeführt wird, so
daß am Ausgang der Mischeranordnung keine Mischprodukte
mit höheren Harmonischen entstehen können - wenn die
Mischeranordnung linear ist, d.h. wenn das Ausgangssignal
der Mischeranordnung genau dem Produkt der Eingangssignale
entspricht.

Bei der zweiten Lösung können am Ausgang der ersten Mischstufe zwar die unerwünschten Mischprodukte mit höheren
Harmonischen entstehen, doch werden diese Mischprodukte
durch die Mischprodukte am Ausgang der weiteren Mischstufen kompensiert.

An dieser Stelle sei erwähnt, daß es aus der DE-PS 25 13 228 an sich bekannt ist, bei einem Stereoempfänger die in einem Rechtecksignal mit Hilfsträgerfrequenz (38 kHz) enthaltene dritte Harmonische dadurch zu kompensieren, daß zwei um 30 Grad gegeneinander versetzte Rechtecksignale mit Hilfsträgerfrequenz einander überlagert werden. Dadurch sollen die Störungen durch die dritte Harmonische des 3 kHz-Rechtecksignals beseitigt werden, die immer dann auftreten, wenn der empfangene Stereosender relativ schwach ist und wenn ihm ein starker Sender benachbart ist. Die höherfrequenten Modulationskomponenten des starken Senders werden durch die dritte Oberwelle (bei 114 kHz) des Hilfsträgers des schwachen Senders in den Hörbereich umgesetzt.

Ist diese Konstellation nicht gegeben, d.h. ist der empfangene Sender relativ stark oder ist ihm kein starker Sender benachbart, dann tritt das beschriebene Problem nicht auf. Bei Empfängern der eingangs genannten Art tritt dieses Problem unabhängig von der Senderkonstellation ebenfalls nicht auf, weil die Zwischenfrequenz dabei so niedrig ist (z.B. 70 kHz), daß die Seitenbänder von starken Sendern in Nachbarkanälen praktisch vollständig unterdrückt werden. - Auf der anderen Seite tritt auch das Problem, um dessen Lösung es bei der Erfindung geht, nur bei Stereempfängern der eingangs genannten Art auf, bei denen der Abstimmoszillator durch das Niederfrequenzausgangssignal moduliert wird, und nicht bei konventionellen Empfängern wie z.B. bei dem in Fig. 1 der DE-PS 25 13 228 dargestellten Empfänger, bei dem eine solche Modulation der Oszillatorfrequenz nicht gegegeben ist. Dieses Problem tritt beim Empfang von Stereosendern immer auf und ist unabhängig davon, ob im Nachbarkanal ein starker Sender vorhanden ist oder nicht.

Die Erfindung bezieht sich somit auf einen anderen Typ von Stereoempfängern als die DE-OS 25 13 228 und ihr liegt auch ein anderes Problem zugrunde wie der bekannten Anordnung.

Die Erfindung wird nachstehend anhand der Zeichnung näher erläutert. Es zeigen

Fig. 1          ein Blockschaltbild der bekannten Schaltung,

Fig. 2a bis 2e ein Frequenzdiagramm zur Erläuterung der bei dem Empfänger nach Fig. 1 auftretenden Störungen,

Fig. 3          eine erste Ausführungsform der Erfindung,

Fig. 4          den Aufbau einer dabei anwendbaren Mischstufe,

Fig. 5          einen Teil einer anderen Ausführungsform der Erfindung, und

Fig. 6          den zeitlichen Verlauf verschiedener Signale bei den erfindungsgemäßen Ausführungsformen.

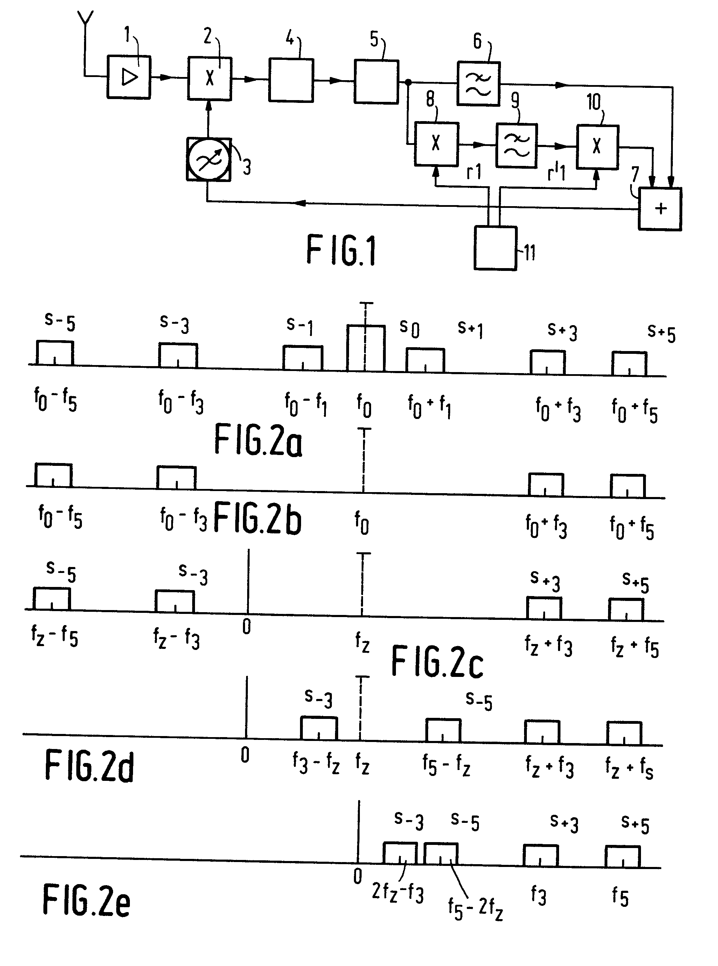

Bei dem in Fig. 1 dargestellten bekannten FM-Stereoempfänger wird das Antennensignal über einen Eingangsverstärker 1 einer Mischstufe 2 zugeführt, in der es mit der von einem in der Frequenz steuerbaren Oszillator 3 gemischt wird. Das Ausgangssignal der Mischstufe 2 wird über einen Zwischenfrequenzverstärker 4 einem FM-Demodulator 5 zugeführt. Dessen Ausgangssignal wird über einen ersten Tiefpaß 6 dem einen Eingang einer Addierschaltung 7 zugeführt und über einen Bandpaß 8 einem anderen Eingang der Addierschaltung. Der Bandpaß besteht aus einer ersten Mischstufe 8, einem zweiten Tiefpaß 9 und einer Mischstufe 10. In der Mischstufe 8 wird das Ausgangssignal des FM-Demodulators mit dem von einer PLL-Schaltung 11 gelieferten Rechtecksignal r1 gemischt. Dadurch werden die beim Empfang von
Stereosignalen beiderseits der Hilfsträgerfrequenz
(38 kHz) auftretenden Seitenbänder in das Niederfrequenzband umgesetzt, so daß am Ausgang der Mischstufe 8 bzw. am
Ausgang des Tiefpasses 9, der die gleiche Grenzfrequenz
hat wie der Tiefpaß 6, das Differenzsignal entsteht, das
ebenso wie das Summensignal am Ausgang des Tiefpasses 6
einer nicht näher dargestellten Dematrizierschaltung zugeführt werden kann, die die Signale für den rechten und den
linken Kanal bildet. Das Ausgangssignal des Tiefpasses 9
wird dem einen Eingang einer Mischstufe 10 zugeführt, an
deren anderem Eingang ein Rechtecksignal r'1 anliegt, das
dieselbe Frequenz aufweist wie das Signal r1, diesem
gegenüber jedoch eine Phasenverschiebung aufweist, durch
die die in den vorangegangenen Bauelementen, insbesondere
im Zwischenfrequenzfilter 4 und im FM-Demodulator 5,erzeugten Phasendrehungen wieder ausgeglichen werden.

Das Ausgangssignal der Addierschaltung 7, das der Summe
der Ausgangssignale des Tiefpasses 6 und der Mischstufe 10
entspricht, wird dem Steuereingang des in der Frequenz
steuerbaren Oszillators 3 zugeführt.

Somit bilden die Bauelemente 2...10 eine Schleife mit
negativer Schleifenverstärkung, die dem Betrage nach
größer als 1 ist (z.B. 4). Durch diese negative Schleifenverstärkung wird der Frequenzhub des vom Eingangsverstärker 1 gelieferten frequenzmodulierten Signals komprimiert,
z.B. im Verhältnis 1:5, so daß ohne Verzerrungen mit einer
sehr niedrigen Zwischenfrequenz, z.B. 70 kHz, gearbeitet
werden kann. Der gesamte Empfänger kann daher in integrierter Schaltungstechnik ausgeführt werden.

0146195

Wie bereits erwähnt, wird in der Mischstufe 10 das Stereo-Differenzsignal mit dem Rechtecksignal r'1 mit Hilfsträgerfrequenz gemischt. Außer den erwünschten Seitenbändern (beiderseits des Hilfsträgers) entstehen dabei durch die im Rechtecksignal r'1 enthaltenen höheren Harmonischen im Ausgangssignal der Mischstufe 10 unerwünschte Mischprodukte - nämlich (Stör-) Seitenbänder beiderseits der dritten, der fünften und hörerer ungeradzahliger Harmonischer. Da der Oszillator auch mit diesen unerwünschten Mischprodukten frequenzmoduliert ist, erscheinen auch an seinem Ausgang Stör-Seitenbänder. Dies ist in Fig. 2a schematisch dargestellt, die das Spektrum der Oszillatorschwingung zeigt. Der zeitliche Mittelwert der Oszillatorschwingung ist dabei mit $f_0$ bezeichnet. Das zugehörige Seitenband ist mit $s_0$ bezeichnet; es entspricht bei einer Stereosendung dem Summensignal für den rechten und den linken Kanal. Im Frequenzabstand $f_1$ des Hilfsträgers ($f_1$ = 38 kHz) befinden sich ein oberes Seitenband $s_{+1}$ und ein unteres Seitenband $s_{-1}$, die beim Empfang eines Stereosignals dem Stereo-Differenzsignal entsprechen. Zum einwandfreien Empfang sind die Seitenbänder $s_0$, $s_{-1}$ und $s_{+1}$ erforderlich. Außer diesen erwünschten Seitenbändern ergeben sich jedoch wie schon erwähnt im Frequenzabstand $f_3 = 3f_1$, $f_5 = 5f_1$, d.h. jeweils im Frequenzabstand eines ungeradzahligen Vielfachen der Hilfsträgerfrequenz weitere obere und untere Seitenbänder, die mit $s_{-3}$, $s_{+3}$, $s_{-5}$ und $s_{+5}$ bezeichnet sind. Die Stör-Seitenbänder, deren Frequenzabstand von der Oszillatorfrequenz $f_0$ das Sieben-, Neun-, Elffache usw. beträgt, sind der Übersichtlichkeit halber nicht dargestellt. - Fig. 2b unterscheidet sich von Fig. 2a dadurch, daß die Nutzseitenbänder $s_0$, $s_{+1}$ und $s_{-1}$ weggelassen sind.

Fig. 2c stellt das Differenzspektrum dar, das sich ergibt, wenn von dem Störspektrum (Fig. 2b) die Trägerfrequenz am Ausgang der Eingangsstufe 1 subtrahiert wird. Die Oszillatorfrequenz $f_0$ geht dann in die Zwischenfrequenz $f_z$ über. Da die Zwischenfrequenz aber verhältnismäßig niedrig liegt (z.B. 70 kHz), liegt die Frequenz-Nullinie zwischen der Zwischenfrequenz und den unteren Stör-Seitenbändern $s_{-3}$ und $s_{-5}$. Diese Störseitenbänder würden also im negativen Frequenzbereich liegen. Bei der Mischung in der Mischstufe 2 werden diese Störseitenbänder jedoch in den positiven Frequenzbereich umgesetzt, d.h. sie werden an der Frequenz-Nullinie gespiegelt, so daß sich am Ausgang der Mischstufe 2 das in Fig. 2d dargestellte Störspektrum ergibt. Das Spektrum am Ausgang des FM-Demodulators 5 unterscheidet sich um den Betrag $f_z$ vom Spektrum nach Fig. 2d. Da $s_{-3}$ jedoch nicht im negativen Frequenzbereich liegen kann, ergibt sich hierfür erneut eine Spiegelung an der Frequenz-Nullinie, so daß am Ausgang des FM-Demodulators das in Fig. 2e dargestellte Störspektrum resultiert.

Die unteren Störseitenbänder $s_{-3}$ und $s_{-5}$ befinden sich dabei in dem beim Empfang von Stereo-Signalen mitverarbeiteten Frequenzbereich. Wenn beispielsweise die Zwischenfrequenz bei 70 kHz liegt, liegt die Mittenfrequenz des Störseitenbandes $s_{-3}$ bei 26 kHz (2 x 70 kHz - 3 x 38 kHz) und die Mittenfrequenz des Stör-Seitenbandes $s_{-5}$ liegt bei 50 kHz ( 5 x 38 kHz - 2 x 70 kHz). Die um diese Frequenzen herum gruppierten Störseitenbänder $s_{-3}$ und $s_{-5}$ werden bei der Demodulation des Differenzsignals in den Niederfrequenzbereich umgesetzt und sind dabei besonders störend.

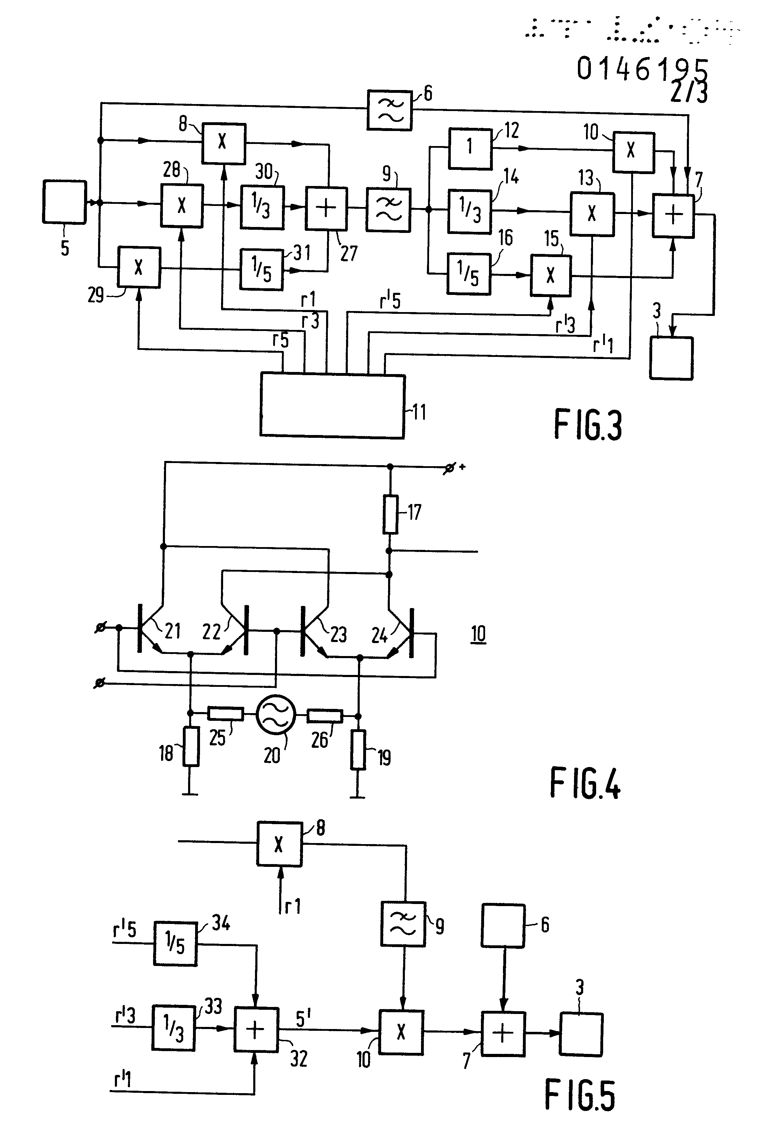

Die Erfindung beseitigt diese Störungen dadurch, daß die unerwünschten Mischprodukte, die die Störseitenbänder hervorrufen, eleminiert werden bzw. dadurch, daß die bei der Mischung benutzten Signale so geformt sind, daß keine unerwünschten Mischprodukte entstehen können. Zum letztgenannten Lösungsweg ist zu bemerken, daß grundsätzlich die unerwünschten Mischprodukte durch Verwendung einer sinusförmigen Spannung mit Hilfsträgerfrequenz beseitigt werden könnten. Sinusförmige Spannungen können jedoch in einer integrierten Schaltung mit vertretbarem Aufwand nicht erzeugt werden. Ein erfindungsgemäßer Empfänger ist mit dem in Fig. 1 dargestellten Empfänger identisch. Lediglich der Bandpaß 8, 9, 10 hat einen anderen Aufbau und nur dieser Teil ist in Fig. 3 als erste Ausführungsform der Erfindung dargestellt.

Das Ausgangssignal des Tiefpasses 9 wird dabei über drei Stellglieder 12, 14 und 16 dem Eingang je einer Mischstufe 10, 13 und 15 zugeführt. Die Stellglieder sind so ausgestaltet, daß die Amplitude des dem Eingang der Mischstufe 10 zugeführten Signals dreimal so groß ist wie die Amplitude des Signals am Eingang der Mischstufe 13 und fünfmal so groß wie die Amplitude am Eingang der Mischstufe 15. In der Mischstufe 10 wird das Signal mit einem Rechtecksignal $r'1$ mit einer Frequenz $f_1$ (38 kHz) gemischt. Dem zweiten Eingang der Mischstufe 13 wird ein Rechtecksignal $r'3$ mit der Frequenz $f_3$ (114 kHz) zugeführt und dem zweiten Eingang der Mischstufe 15 wird ein Rechtecksignal $r'5$ mit dem Fünffachen der Trägerfrequenz (190 kHz) zugeführt.

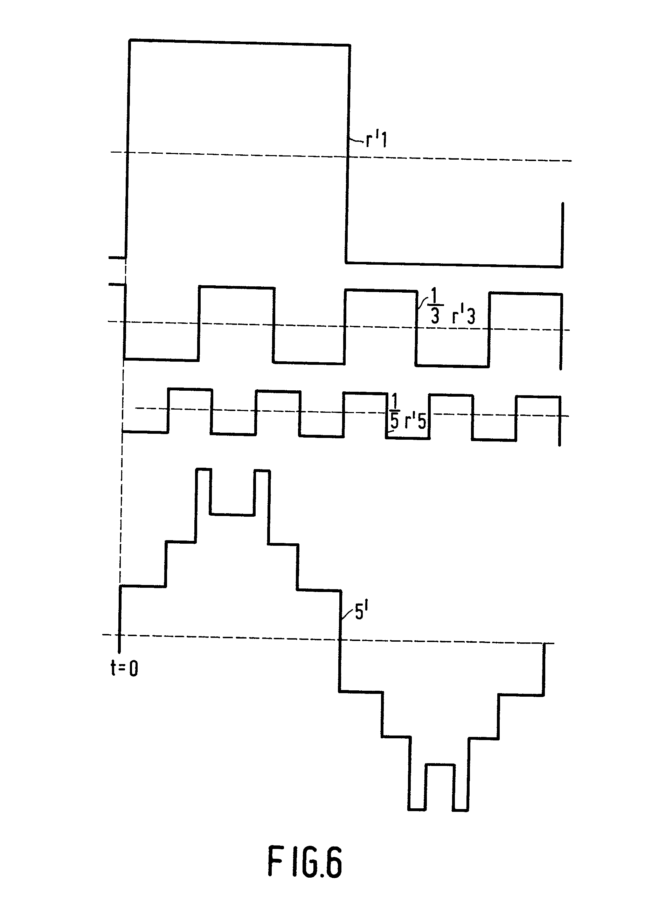

Der zeitliche Verlauf der Rechtecksignale $r'1$. $r'3$ und $r'5$ ergibt sich aus Fig. 6. Alle Rechtecksignale sind symmetrisch, d.h. es gibt innerhalb einer Periode nur zwei Signalzustände bzw. Spannungswerte, die gleich lange dauern und zwischen denen das Signal hin und her springt. Die Flanken des Rechtecksignals $r'1$ fallen zeitlich mit Flanken der Rechtecksignale $r'3$ und $r'5$ zusammen, wobei immer eine positive (ansteigende) Flanke des Rechtecksignals $r'1$ mit einer negativen Flanke der Signale $r'3$ und $r'5$ und eine negative Flanke des Signals $r'1$ mit positiven Flanken der Signale r'3 und r'5 zusammenfallen, wie aus Fig. 6 ersichtlich ist.

Die Ausgänge der Mischstufen 10, 13 und 15 sind mit den
Eingängen der Addierschaltung 7 verbunden.

Zur Erläuterung der Wirkung der Erfindung sei angenommen,
daß die Mischstufen 10, 13 und 15 alle linear sind, d.h.
daß ihr Ausgangssignal dem Produkt der Eingangssignale
streng proportional ist und daß am Ausgang des Tiefpasses
9 das Differenzsignal f(t) anliegt. Dann ergibt sich am
Ausgang der Mischstufe 10 das Signal

$$m_{10} = f(t) \cdot r'1(t) \qquad (1)$$

Das Rechtecksignal r'1(t) läßt sich dabei in eine Fourierreihe zerlegen:

$$r'1(t) = 4a/\pi \cdot (\sin wt + (\sin 3wt)/3 + (\sin 5wt)/5 + \ldots \qquad (2)$$

Dabei ist a die Amplitude des Rechtecksignals und w ist
die Kreisfrequenz des Hilfsträgers. Der erste Summand in
dem Klammerausdruck entspricht dabei der Grundschwingung
des Hilfsträgers, die die erwünschten Mischprodukte
liefert, während der zweite und die folgenden Summanden
den (ungeradzahligen) höheren Harmonischen der Grundschwingung entsprechen. Vernachlässigt man die siebte und
alle weiteren höheren Harmonischen ergibt sich am Ausgang
der Mischstufe 10 das Signal

$$m_{10} = f(t) \cdot 4a/\pi(\sin wt + (\sin 3wt)/3 + (\sin 5wt)/5 \qquad (3)$$

Auf ähnliche Weise ergibt sich das Ausgangssignal $m_{13}$ am
Ausgang der Mischstufe 13 zu

$$m_{13} = -f(t)/3 \cdot 4a/\pi \; (\sin 3wt)+(\sin 9wt)/3+...) \qquad (4)$$

Das Minuszeichen ist dabei darauf zurückzuführen, daß zur Zeit t = 0 der negative Anteil des Signals r'3 beginnt. Entsprechend ergibt sich für das Ausgangssignal $m_{15}$ am Ausgang der Mischstufe 15

$$m_{15} = -f(t)/5 \cdot 4a/\pi \; (\sin 5wt+(\sin 15wt)/3a...) \qquad (5)$$

Als Ergebnis $m_7$ der Addition der Ausgangssignale der drei Mischstufen ergibt sich dann

$$m_7 \;\;\; = ft) \cdot 4a/\pi \cdot \sin wt \qquad (6)$$

Man erkennt, daß die Mischprodukte, die auf die dritte und die fünfte Harmonische zurückgehen, verschwunden sind, und es bleiben nur noch Mischprodukte mit der siebten und höheren Harmonischen. Falls diese noch stören sollten, könnten sie durch Rechtecksignale mit der siebenfachen Frequenz der Trägerschwingung bzw. einer noch höheren Frequenz in analoger Weise beseitigt werden.

Aus dem vorhergehenden ergibt sich, daß die Stellglieder auch hinter der Mischstufe angeordnet sein können; bei linearen Mischstufen können die Rechtecksignale den Mischstufen auch über die Einstellglieder zugeführt werden. - Es ist auch nicht wesentlich, daß die Ausgangssignale der Mischstufen addiert werden, denn wenn die positiven Flanken des Rechtecksignals r'1 jeweils mit einer positiven Flanke der Signale r'3 und r'5 zusammenfallen, ergibt sich eine Befreiung von den unerwünschten Mischprodukten, wenn die Ausgangssignale der Mischstufen 13 und 15 vom Ausgangssignal der Mischstufe 10 subtrahiert werden.

In Fig. 4 ist ein Ausführungsbeispiel einer geeigneten Mischstufe dargestellt. Sie umfaßt ein erstes Transistorpaar 21, 22, dessen Emitterelektroden miteinander verbunden sind, und ein zweites Transistorpaar 23, 24, dessen Emitterelektroden ebenfalls miteinander verbunden sind. Die Basiselektroden der Transistoren 22 und 23 einerseits und der Transistoren 21 und 24 andererseits sind miteinander verbunden. Ebenso ist der Kollektor des Transistors 23 und der Kollektor des Transistors 22 mit dem Kollektor des Transistors 24 verbunden, wobei in der Kollektorzuleitung der letztgenannten Transistoren ein Widerstand 17 angeordnet ist, an dem das Ausgangssignal abnehmbar ist. Der Emitter-Gleichstrom für die Transistorpaare 21 und 22 bzw. 23 und 24 wird durch einen Widerstand 18 bzw. 19 bestimmt, der die Emitterelektroden des Transistorpaares mit Masse verbindet. Der Emitter-Wechselstrom wird von einer Spannungsquelle 20 erzeugt, die über Widerstände 25 bzw. 26 mit den Transistorpaaren 21, 22 bzw. 23, 24 verbunden ist und diesen gegenphasig ein dem Ausgangssignal des Tiefpasses 9 entsprechendes Signal zuführt.

Da die gleich großen Widerstände 25 und 26 den Emitter-Wechselstrom bestimmen, ist es zweckmäßig, diese Widerstände für die Mischstufe 15 fünfmal so groß (und für die Mischstufe 13 dreimal so groß) zu machen wie für die Mischstufe 10, so daß sich die Emitter-Wechselströme für die Mischstufen 10, 13 und 15 wie 1:3:5 verhalten würden, so daß die Einstellglieder 12, 14, 16 überflüssig wären. Eine weitere Besonderheit der Mischstufe 10 ist, daß das Ausgangssignal am Kollektor-Widerstand 17 nur proportional zum Signal der Signalquelle 20 ist, nicht aber proportional zu der Spannung zwischen den Basiselektroden, die als Eingang für das jeweilige Rechtecksignal dienen, falls die Rechtecksignale eine Amplitude haben, die zur Sperrung entweder der Transistoren 22, 23 bzw. 23, 24 ausreicht. Trotzdem ergeben sich die erwünschten Mischprodukte, wenn die Amplitude der den Basiselektroden zugeführten Rechtecksignale so groß gewählt ist, daß die Transistoren 21,

0146195

24 und 22, 23 abwechselnd ein- und ausgeschaltet werden. Die drei Mischstufen benötigen insgesamt nur einen Ausgangswiderstand 17, an dem dann das von Mischprodukten mit der dritten und fünften Harmonischen der Trägerfrequenz freie Ausgangssignal abgenommen werden kann.

Grundsätzlich ist es ebenso wie bei dem bekannten Empfänger nach Fig. 1 möglich, als Eingangssignal des Tiefpasses 9 das Ausgangssignal der vorangehenden Mischstufe 8 zu verwenden, in der das Ausgangssignal des FM-Demodulators 5 mit einem Rechtecksignal r1 mit Trägerfrequenz gemischt wird, das gegenüber dem Rechtecksignal r'1 in der Phase verschoben ist. Bei dem Ausführungsbeispiel nach Fig. 3 wird das Ausgangssignal der Mischstufe 8, im Tiefpaß 9 jedoch über eine Addierschaltung 27 zugeführt, in der zu dem Ausgangssignal der Mischstufe die Ausgangssignale weiterer Mischstufen 28 und 29 addiert werden, die den Eingängen der Addierschaltung 27 über Schaltungen 30 und 31 zugeführt werden, in denen das Ausgangssignal der Mischstufen auf ein Drittel bzw. ein Fünftel herabgesetzt wird. In den Mischstufen 28 und 29 werden die Demodulator-Ausgangssignale mit Rechtecksignalen r3 und r5 mit der Dreifachen bzw. der fünffachen Frequenz des Hilfsträgers gemischt. Die Rechtecksignale r1, r3 und r5 haben zueinander die gleiche Phasenlage wie die Signale r'1, r'3 und r'5 (vgl. Fig. 6).

Der Zweck der zusätzlichen Mischstufen 28 und 29 und der anschließenden Addition besteht darin, die Mischprodukte zu eleminieren, die sich ergeben, wenn an dem mit dem Demodulatorausgang verbundenen Eingang der Mischstufe 8 ein Störsignal mit annähernd der dreifachen bzw. der fünffachen Frequenz des Hilfsträgers auftritt. Diese Störsignale würden durch Mischung mit der im Rechtecksignal r1 enthaltenen Harmonischen in den Niederfrequenzbereich umgesetzt und könnte daher auch durch den Tiefpaß 9 nicht beseitigt werden. Die Beseitigung dieser unerwünschten Mischprodukte erfolgt wie im Zusammenhang mit den Mischstufen 10, 13 und 15 erläutert. ·

Die PLL-Schaltung 11, die die Rechtecksignale r1, r3, 5 und r'1, r'3 und r'5 liefert, enthält zweckmäßigerweise einen Oszillator der auf dem Fünfzehnfachen der Hilfsträgerfrequenz bzw. einem Vielfachen davon, z.B. 4,56 MHz schwingt. Zur Erzeugung des erforderlichen Phasenunterschiedes (zwischen r1, r'1 bzw. r3, r'3 oder r5, r'5) kann ein geeignetes Phasendrehglied vorgesehen sein, und die jeweils benötigte Frequenz kann mit Hilfe von Frequenzteilern aus der Oszillatorfrequenz abgeleitet werden.

Bei der Ausführungsform nach Fig. 3 entstehen zwar am Ausgang der Mischstufe 10 im Bereich der dritten und fünften Harmonischen unerwünschte Mischprodukte, doch werden diese Mischprodukte durch gleich große Mischprodukte mit entgegengesetzter Polarität am Ausgang der Mischstufen 13 und 15 kompensiert. Demgegenüber ist in Fig. 5 eine Ausführungsform dargestellt, bei der Mischprodukte mit der dritten und fünften Harmonischen gar nicht erst entstehen können, weil das Ausgangssignal des Tiefpasses 9 in der Mischstufe 10 mit einem nicht sinusförmigen Signal mit Trägerfrequenz gemischt wird, das frei von dritten und fünften sowie von geradzahligen Harmonischen ist. Ein Verfahren zum Erzeugen eines derartigen Signals ist in der deutschen Patentanmeldung P 33 11 072 beschrieben, bei dem der sinusförmige Verlauf stückweise durch Geraden mit bestimmter Steigerung approximiert wird.

Bei der Ausführungsform nach Fig. 5 wird das von geradzahligen und von der dritten und der fünften Harmonischen freie Signal mit Trägerfrequenz jedoch auf andere Weise erzeugt. Dabei wird dem ersten Eingang einer Additionsschaltung 32 das Rechtecksignal r'1 zugeführt, einem zweiten Eingang der Additionsschaltung 32 wird das Signal r'3, das die dreifache Frequenz aufweist, über ein Stellglied 33 mit einem Drittel der Amplitude von r'1 zugeführt, während einem dritten Eingang der Additionsschaltung 32 das Rechtecksignal r'5 über ein Stellglied 34

mit der fünffachen Frequenz und einem Fünftel der Amplitude von r'1 zugeführt wird. Der zeitliche Verlauf der Rechtecksignale an den drei Eingängen der Additionsschaltung ergibt sich aus Fig. 6 und ebenso das daraus resultierende Summensignal s'.

Dieses Summensignal s' enthält außer der Grundwelle keine geradzahligen Harmonischen und lediglich die siebte und höhere ungeradzahlige Harmonische; die dritte und fünfte Harmonische sind unterdrückt. Infolgedessen ergeben sich am Ausgang der Mischstufe 10 keinerlei Mischprodukte mit der dritten und fünften Harmonischen.Da die Mischstufe 10 linear arbeiten muß, muß in diesem Fall eine Mischstufe verwendet werden, deren Ausgangssignal sich proportional zum Produkt der Eingangssignale ändert, d.h. z.B. eine Multiplizierstufe.

0146195

PATENTANSPRÜCHE

1.  FM-Stereoempfänger mit einem Oszillator, dessen Frequenz in Abhängigkeit von einem Signal an seinem Steuereingang steuerbar ist, einer Mischstufe, die das Oszillatorsignal mit einem hochfrequenten Eingangssignal mischt und ein ZF-Signal bildet, einem FM-Demodulator, dem das ZF-Signal zugeführt und dessen Ausgangssignal dem Steuereingang des Oszillators über einen ersten Tiefpaß sowie über einen in einem Parallelzweig befindlichen Bandpaß zugeführt wird, der einen Demodulator zum Erzeugen eines Stereo-Differenzsignals beim Empfang einer Stereosendung enthält, dem ein zweiter Tiefpaß nachgeschaltet ist, dessen Ausgangssignal in einer ersten Mischeranordnung mit einem nicht sinusförmigen Signal mit Hilfsträgerfrequenz gemischt wird,

dadurch gekennzeichnet, daß das der ersten Mischeranordnung (10) zugeführte nicht sinusförmige Signal (s') frei von dritten und fünften Harmonischen der Hilfsträgerfrequenz ist.

2.  FM-Stereoempfänger mit einem Oszillator, dessen Frequenz in Abhängigkeit von einem Signal an seinem Steuereingang steuerbar ist, einer Mischstufe, die das Oszillatorsignal mit einem hochfrequenten Eingangssignal mischt und ein ZF-Signal bildet, einem FM-Demodulator, dem das ZF-Signal zugeführt und dessen Ausgangssignal dem Steuereingang des Oszillators über einen ersten Tiefpaß sowie über einen in einem Parallelzweig befindlichen Bandpaß zugeführt wird, der einen Demodulator zum Erzeugen eines Stereo-Differenzsignals beim Empfang einer Stereosendung enthält, dem ein zweiter Tiefpaß nachgeschaltet ist,

0146195

dessen Ausgangssignal in einer ersten Mischeranordnung mit einem nicht sinusförmigen Signal mit Hilfsträgerfrequenz gemischt wird,
dadurch gekennzeichnet, daß die erste Mischeranordnung eine erste Mischstufe (10) umfaßt, in der das Ausgangssignal des Tiefpasses (9) mit einem Rechtecksignal (r'1) mit der Hilfsträgerfrequenz gemischt wird, und wenigstens noch zwei weitere Mischstufen (13, 15), in denen das Ausgangssignal des Tiefpasses mit Rechtecksignalen (r'3, r'5) mit der dreifachen, der fünffachen und ggf. weiteren ungeradzahligen Vielfachen der Hilfsträgerfrequenz gemischt wird, und daß die Ausgangssignale der weiteren Mischstufen (13, 15) dem Ausgangssignal der ersten Mischstufe (10) mit solcher Amplitude und Phasenlage überlagert werden, daß die im Ausgangssignal der ersten Mischstufe enthaltenen Mischprodukte zumindest mit der dreifachen und der fünffachen Frequenz des Hilfsträgers wenigstens teilweise kompensiert werden (Fig. 3).

3.    Empfänger nach Anspruch 1,
dadurch gekennzeichnet, daß Rechtecksignale (r'1, r'3, r'5) mit der Frequenz des Hilfsträgers, mit der dreifachen, der fünffachen und ggf. weiteren ungeradzahligen Vielfachen der Hilfsträgerfrequenz erzeugt und mit solcher Amplitude und Phasenlage einander überlagert werden, daß die in dem Rechtecksignal (r'1) mit der Hilfsträgerfrequenz enthaltenen Harmonischen zumindest mit der dreifachen und der fünffachen Hilfsträgerfrequenz kompensiert werden, und daß das Überlagerungssignal (s') einem Eingang der ersten Mischeranordnung (10) zugeführt wird (Fig. 5).

0146195
PHD 83-122EP

4.    Empfänger nach Anspruch 2 oder 3,
dadurch gekennzeichnet, daß die Rechtecksignale über Frequenzteiler aus einem Oszillator abgeleitet werden, dessen Frequenz das Fünfzehnfache der Hilfsträgerfrequenz oder ein Vielfaches davon beträgt.

5.    Empfänger nach einem der vorhergehenden Ansprüche, dadurch gekennzeichnet, daß der Demodulator eine zweite Mischeranordnung (8) umfaßt, in der das Ausgangssignal des FM-Demodulators (5) mit einer Kombination von Rechtecksignalen (r1, r3, r5) mit einem ungeradzahligen Vielfachen der Hilfsträgerfrequenz gemischt wird, und daß die Kombination so gewählt ist, daß zumindest die Mischprodukte mit der dritten und fünften Harmonischen der Hilfsträgerfrequenz kompensiert werden.

FIG.1

$s-5$    $s-3$    $s-1$    $s_0$    $s+1$    $s+3$    $s+5$

$f_0-f_5$    $f_0-f_3$    $f_0-f_1$    $f_0$    $f_0+f_1$    $f_0+f_3$    $f_0+f_5$

FIG.2a

$f_0-f_5$    $f_0-f_3$ FIG.2b    $f_0$    $f_0+f_3$    $f_0+f_5$

$s-5$    $s-3$    $s+3$    $s+5$

$f_z-f_5$    $f_z-f_3$    $0$    $f_z$    $f_z+f_3$    $f_z+f_5$

FIG.2c

$s-3$    $s-5$

FIG.2d    $0$    $f_3-f_z$   $f_z$    $f_5-f_z$    $f_z+f_3$    $f_z+f_s$

$s-3$    $s-5$    $s+3$    $s+5$

FIG.2e    $0$   $2f_z-f_3$    $f_5-2f_z$    $f_3$    $f_5$

FIG.3

FIG.4

FIG.5

FIG.6